(19)

**Europäisches Patentamt**

**European Patent Office**

**Office européen des brevets**

(11) **EP 4 131 265 B1**

(12) **EUROPEAN PATENT SPECIFICATION**

(45) Date of publication and mention
of the grant of the patent:
**11.06.2025 Bulletin 2025/24**

(21) Application number: **22184919.3**

(22) Date of filing: **14.07.2022**

(51) International Patent Classification (IPC):
**G10L 21/0364** (2013.01)   **H03G 5/16** (2006.01)
**H04S 7/00** (2006.01)   **H03G 3/30** (2006.01)
**G10L 25/78** (2013.01)

(52) Cooperative Patent Classification (CPC):
**G10L 21/0364; H03G 3/3005;** G10L 25/78;
H04R 2430/01; H04S 2400/13

(54) **METHOD AND SYSTEM FOR DYNAMIC VOICE ENHANCEMENT**

VERFAHREN UND SYSTEM ZUR DYNAMISCHEN SPRACHVERBESSERUNG

PROCÉDÉ ET SYSTÈME D'AMÉLIORATION DYNAMIQUE DE LA VOIX

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.08.2021 CN 202110895493**

(43) Date of publication of application:
**08.02.2023 Bulletin 2023/06**

(73) Proprietor: **Harman International Industries, Inc.
Stamford, Connecticut 06901 (US)**

(72) Inventors:
• **SHIH, Shao-Fu
  Mountain View, 94043 (US)**
• **ZHENG, Jianwen
  Shenzhen, 518067 (CN)**
• **XIAO, Yi
  Shenzhen, 518067 (CN)**
• **JIAO, Evin
  Shenzhen, 518052 (CN)**

(74) Representative: **Kraus & Lederer PartGmbB
Thomas-Wimmer-Ring 15
80539 München (DE)**

(56) References cited:
**US-A1- 2006 053 007**   **US-A1- 2010 179 808**
**US-A1- 2013 003 987**   **US-A1- 2015 215 467**
**US-A1- 2016 071 527**   **US-A1- 2019 172 476**
**US-B2- 8 577 676**

• **HOUMAN GHAEMMAGHAMI ET AL: "Noise
Robust Voice Activity Detection Using Features
Extracted From the Time-Domain
Autocorrelation Function", PROCEEDINGS OF
INTERSPEECH 2010, 1 January 2010
(2010-01-01), Makuhari, Japan, XP055241947,
Retrieved from the Internet <URL:http://eprints.
qut.edu.au/40656/1/
2011006688_H_Ghaemmaghami_ePrints.pdf>
[retrieved on 20160115]**

## Description

### Technical Field

The present disclosure relates generally to the field of audio signal processing, and more particularly, to a method and system for dynamic voice enhancement of an audio source.

### Background

Thanks to new ways of media consumption such as high-definition cable TV and online streaming, and with the advent of large-screen TVs and displays, the cinema experience is gaining popularity in the consumer market. These media sources are often accompanied by multi-channel audio technology or commonly referred to as surround technology. Surround providers such as Dolby, THX, and DTS have their own multi-channel audio encoding technology that provides a better spatial audio resolution for source content. Since the main purpose of content in a movie format is to provide an immersive surround experience, it is often preferred to sacrifice voice intelligibility in favor of the surround experience. While this provides great benefits in terms of immersion and spatial resolution, it often results in poor voice quality and sometimes even difficulty in understanding the movie content. In order to improve the quality of voice in a movie content source to improve intelligibility and audibility, methods of voice enhancement are often applied to the movie content.

A common method for existing voice enhancement is to utilize static equalization. This method applies static equalization only on an audio channel about 200 Hz to 4 kHz to increase the loudness of a voice band. This implementation requires very few system resources, but the distortion that occurs in this method is obvious. Since this implementation method works all the time even when there is no voice or dialogue in a clip, a pitch imbalance will be caused, and the background will be amplified. A more advanced method is to first detect voice within each time frame, and then automatically process an audio signal based on the detection result. This one-way execution method requires accurate detection of voice and fast response of system processing. However, some existing methods cannot detect voice quickly and accurately, and often color a signal so that it sounds harsh. US 2010/0179808 A1 discloses a method for enhancing speech with flattening a spectrum of a center channel.

Therefore, there is a need for an improved technical solution to overcome the above-mentioned shortcomings in the existing solutions and to provide an optimized approach for calculating a voice detection confidence.

### Summary

According to an aspect of the present disclosure, a method of dynamic voice enhancement is provided as mentioned in claim 1. The method includes inter alia performing a first path signal processing, the first path signal processing including receiving an audio source input and performing dynamic loudness balancing on the audio source input based on a first gain control parameter. The method also includes: performing a second path signal processing, the second path signal processing including performing voice detection on the audio source input and calculating a detection confidence, wherein the detection confidence indicates the possibility of voice in the audio source input; and calculating a second gain control parameter based on the detection confidence. The method further includes updating the first gain control parameter with the second gain control parameter, and performing the first path signal processing based on the updated first gain control parameter.

According to the invention, the audio source input includes a multi-channel source input, and the performing voice detection on the audio source input and calculating a detection confidence includes: extracting a center channel signal from the multi-channel source input; performing normalization on the center channel signal; and performing fast autocorrelation on the normalized center channel signal, the result of the fast autocorrelation representing the detection confidence.

According to one or more embodiments, the calculating a second gain control parameter based on the detection confidence may include: calculating the second gain control parameter based on a logarithmic function of the detection confidence; smoothing the calculated second gain control parameter; and limiting the smoothed second gain control parameter.

According to one or more embodiments, the audio source input may include a multi-channel source input, and the performing dynamic loudness balancing on the audio source input includes: extracting a center channel signal from the multi-channel source input; enhancing the loudness of the center channel signal and reducing the loudness of other channel signals based on the first gain control parameter or the updated first gain control parameter; and concatenating and mixing the enhanced center channel signal and the reduced other channel signals to generate an output signal.

According to one or more embodiments, the method may also include performing crossover filtering on the audio source input before performing the dynamic loudness balancing.

According to one or more embodiments, the method may also include: performing the dynamic loudness balancing only on signals in a mid frequency range of the audio source input; and concatenating and mixing signals in a low frequency range and a high frequency range of the audio source input and signals in the mid frequency range of the audio source input after the dynamic loudness balancing to generate the output signal.

According to one or more embodiments, the audio source input also includes a dual-channel source input, and the method also includes generating a multi-channel source input based on the dual-channel source input.

According to one or more embodiments, the generating a multi-channel source input based on the dual-channel source input may include: performing a cross-correlation between a left channel signal and a right channel signal from the dual-channel source input; and generating the multi-channel source input according to a combination ratio. The combination ratio depends on the result of the cross-correlation.

According to one or more embodiments, the first path signal processing and the second path signal processing are synchronous or asynchronous.

According to another aspect of the present disclosure, a system for voice enhancement is provided, including: a memory and a processor. The memory is configured to store computer-executable instructions. The processor is configured to execute the instructions to implement the method described above.

## Brief Description of the Drawings

The present disclosure may be better understood by reading the following description of nonlimiting implementations with reference to the accompanying drawings, in which:

FIG. 1 schematically shows a schematic block diagram of voice enhancement according to one or more embodiments of an implementation of the present disclosure;

FIG. 2 exemplarily shows a schematic block diagram of voice detection according to one or more embodiments of the present disclosure;

FIG. 3 exemplarily shows a schematic block diagram of gain estimation based on voice detection according to one or more embodiments of the present disclosure;

FIG. 4 exemplarily shows a schematic diagram of a dynamic loudness balancing process according to one or more embodiments of the present disclosure;

FIG. 5 shows a schematic diagram of voice enhancement according to one or more embodiments of another implementation of the present disclosure;

FIG. 6 shows a schematic diagram of a dynamic loudness balancing process according to one or more embodiments of the implementation in FIG. 5;

FIG. 7 schematically shows a process of generating a multi-channel source input based on a dual-channel source input in the case where a source input is the dual-channel source input, according to one or more embodiments of the present disclosure; and

FIG. 8 schematically shows a method for dynamic voice enhancement according to one or more embodiments of the present disclosure.

## Detailed Description

It should be understood that the following description of the embodiments is given for purposes of illustration only and not limitation. The division of examples in functional blocks, modules or units shown in the figures should not be construed as implying that these functional blocks, modules or units must be implemented as physically separate units. The functional blocks, modules or units shown or described may be implemented as separate units, circuits, chips, functional blocks, modules, or circuit elements. One or more functional blocks or units may also be implemented in a common circuit, chip, circuit element, or unit.

The use of singular terms (for example, but not limited to, "a") is not intended to limit the number of items. Relational terms, for example but not limited to, "top," "bottom," "left," "right," "upper," "lower," "down," "up," "side," "first," "second" ("third," etc.), "entry," "exit," etc., are used in the written description for clarity in specific reference to the drawings and are not intended to limit the scope of the present disclosure, unless otherwise noted. The terms "couple," "coupling," "being coupled," "coupled," "coupler," and similar terms are used broadly herein and may include any method or device for fixing, bonding, adhering, fastening, attaching, associating, inserting, forming thereon or therein, communicating with, or otherwise directly or indirectly mechanically, magnetically, electrically, chemically, and operatively associated with an intermediate element and one or more members, or may also include, but is not limited to, one member being integrally formed with another member in a unified manner. Coupling may occur in any direction, including rotationally. The terms "including" and "such as" are illustrative rather than restrictive, and the word "may" means "may, but not necessarily," unless stated otherwise. Although any other language is used in the present disclosure, the embodiments shown in the figures are examples given for purposes of illustration and explanation and are not the only embodiments of the subject matter herein.

In order to overcome the defects of the existing technical solutions and improve the quality of voice output so as to bring a better experience to users, the present disclosure proposes a solution of actively detecting human voice and dynamically enhancing voice loudness in an audio source (for example, a theater audio source) based on a detection confidence that indicates the possibility of voice in an audio source input. The method and system of the present disclosure may simultaneously perform signal processing of two paths on an input signal. The first path signal processing includes receiving an audio source input and performing dynamic loudness balancing on the audio source input based on a first gain control parameter. The second path signal processing includes: performing voice detection on the audio source input and calculating a detection confidence; and calculating a second gain control parameter based on the detection confidence. The first path signal processing and the second path signal processing may be synchronous or asynchronous. The method of the present disclosure also includes updating the first gain control parameter with the second gain control parameter calculated by a second processing path, and performing the first path signal processing based on the updated first gain control parameter. The method and system of the present disclosure can better enhance the intelligibility of voice and improve the user's experience of using audio products.

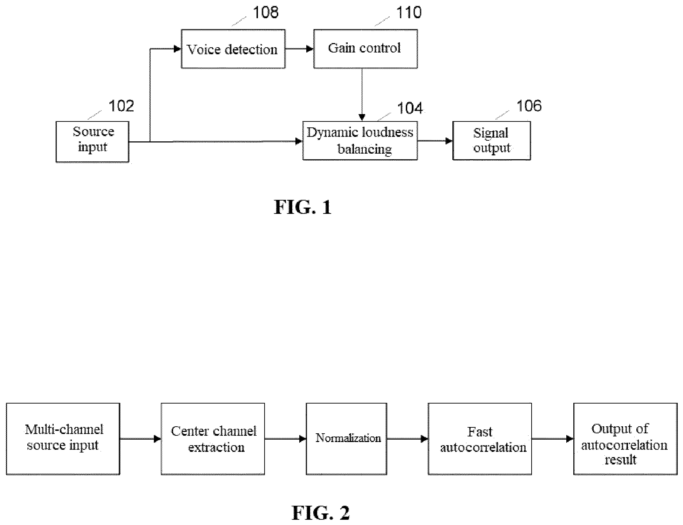

The method and system of dynamic voice enhancement according to various embodiments of various implementations of the present disclosure will be described in detail below with reference to the accompanying drawings. FIG. 1 shows a schematic block diagram of a voice method and system according to one or more embodiments of an implementation of the present disclosure. For ease of understanding, the present disclosure will be described with reference to several modules according to main processing procedures of the method and system. It will be appreciated by those skilled in the art that the reference to the module description is for the purpose of describing the solution more clearly, but not for the purpose of limitation.

FIG. 1 shows a schematic diagram according to one or more embodiments of an implementation of the present disclosure. In one or more embodiments shown in FIG. 1, the method and system of processing audio source input signals in the present disclosure involve the following parts: source input module 102, dynamic loudness balancing module 104, signal output module 106, voice detection module 108, and gain control module 110. As can be seen from FIG. 1, the method and system of the present disclosure may simultaneously perform signal processing of two paths on an input signal. The first path signal processing is mainly used to perform dynamic loudness balancing on a received source input signal. The second path signal processing is used to perform voice detection on the received source input signal and estimate a gain. The first path signal processing and the second path signal processing may be performed synchronously or asynchronously. This depends on the processing power and latency requirements of an actual system. This dual-path processing design for source input signals minimizes the delay and prevents audio distortion. For example, when the first path signal processing and the second signal processing are performed asynchronously, on the one hand, a signal may pass through the entire system quickly and with low delay; on the other hand, a gain may be estimated at a relatively low rate, so that the estimated gain has a higher accuracy and smoothness, which is a huge help in preventing audio distortion.

Referring to FIG. 1, for example, the first path signal processing may include: receiving an audio source input signal through source input module 102, and performing dynamic balancing on the received audio source input signal based on a current gain control parameter through dynamic loudness balancing module 104. The second path processing may include: detecting the audio source input signal received from input module 102 at voice detection module 108 and calculating a detection confidence. For example, the second path processing also includes: gain control module 110 may estimate a new gain control parameter based on the calculated detection confidence.

The new gain control parameter estimated by gain control module 110 may be used to update the gain control parameter currently used by dynamic loudness balancing module 104. Thus, dynamic loudness balancing module 104 may perform the first path signal processing based on the updated gain control parameter. That is, dynamic loudness balancing module 104 may perform dynamic loudness balancing on the received audio source input signal based on the updated gain control parameter. The audio signal after the dynamic loudness balancing may be output through signal output module 106.

The audio source input includes a multi-channel source input, a dual-channel source input, and a single-channel source input. The processing procedures of different source inputs will be described below respectively with reference to the accompanying drawings. FIG. 2 exemplarily shows a schematic block diagram of voice detection according to one or more embodiments of the present disclosure, where the audio input source includes a multi-channel source input. The voice detection process shown in FIG. 2 may be performed, for example, by voice detection module 108 in FIG. 1. As shown in FIG. 2, center channel extraction is performed first, that is, center channel signals are extracted from the multi-channel source input. Usually, most of voice signals exist in a center channel. Then, normalization is performed on the extracted center channel signals so that the input signal is scaled to a similar level. The normalized signal is, for example, represented by the following equation (1):

$$x_{i\_norm}(n) = (x_i(n) - \mu_i)/\sigma_i \tag{1}$$

where $x_i(n)$ represents an input signal at an nth sampling point of an ith time frame, and $x_{i\_norm}(n)$ represents an output signal at the nth sampling point of the ith time frame, that is, the normalized signal. $\mu_i$ and $\sigma_i$ are the mean and variance of the input signals corresponding to the ith time frame.

Next, fast autocorrelation processing is performed on the normalized signal and an autocorrelation result is output. For example, the fast autocorrelation processing may first perform a Fourier transformation on the normalized input signal by using a short-time Fourier transform (STFT) method, and perform fast autocorrelation on the Fourier transformed signal. For example, the fast autocorrelation processing procedure is shown in the following equations (2)-(4).

$$X_i(z) = \text{STFT}\left(x_{i\_norm}(n)\right) \tag{2}$$

$$c_i(n) = \text{iSTFT}\left(X_i(z) * \overline{X_i(z)}\right) \tag{3}$$

$$C_i = \text{norm}\left(c_i(n)\right) \tag{4}$$

where $X_i(z)$ is a Fourier transformed signal, $\overline{X_i(z)}$ represents a conjugate of $X_i(z)$, iSTFT is an inverse short-time Fourier transformation, and $c_i(n)$ is an autocorrelation of a signal of an ith time frame. Next, a norm of $c_i(n)$ is calculated to obtain $C_i$. For example, an output $C_i$ of the final autocorrelation result is obtained based on a Euclidean norm. The output $C_i$ of the autocorrelation result represents the detection confidence, which may indicate the possibility of voice in the center channel signal.

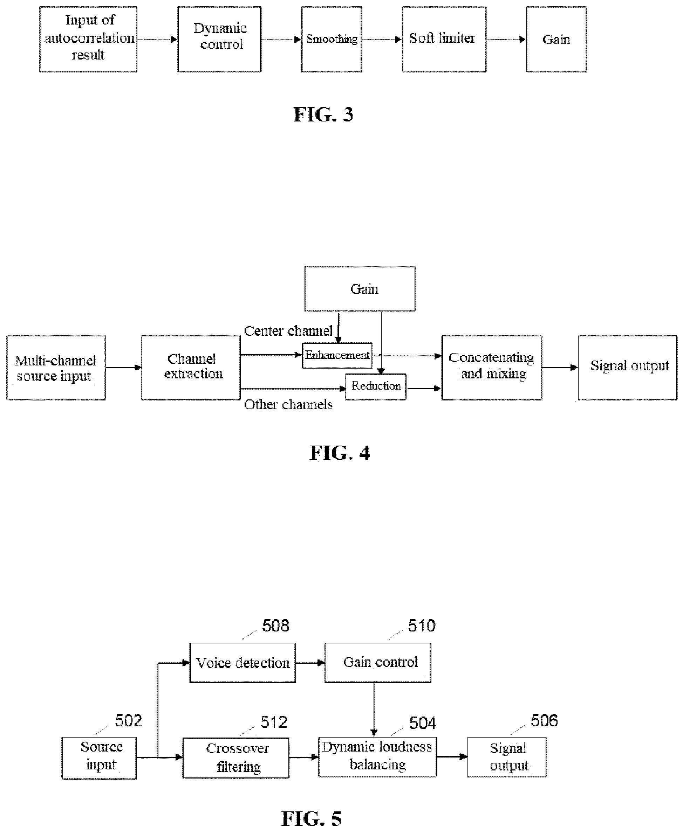

FIG. 3 exemplarily shows a schematic block diagram of a method and system of estimating a dynamic gain based on voice detection according to one or more embodiments of the present disclosure. The process of estimating a dynamic gain based on voice detection shown in FIG. 3 may be performed, for example, by gain control module 110 in FIG. 1. For example, the detection confidence $C_i$ generated via voice detection module 108 with reference to the process shown in FIG. 2 serves as an input to gain control module 110. Based on the input, the gain for voice (which may also be referred to as a gain control parameter hereinafter) is output after processing in gain control module 110 as an input to dynamic loudness balancing module 104. **In** some examples, the dynamic range of the gain is calculated by the following equation (5):

$$G_i = D_0 * \ln(C_i + D_1) \tag{5}$$

where $G_i$ represents an output of a dynamic control module; $D_0$ and $D_1$ are control parameters of a dynamic gain fluctuation range, which may be real numbers greater than zero; and $\ln(\cdot)$ is a natural logarithmic function. In some examples, $G_i$ may be provided to dynamic loudness balancing module 104 as an output from gain control module 110.

In some other examples, $G_i$ may be further processed and then serve as an output from gain control module 104. For example, $G_i$ is smoothed to reduce audio distortion. In addition, a soft limiter may also be used to ensure that the gain $G_{i\_lim}$ is within a reasonable range of magnitude. For example, a tangent function of the following equation (6) may be used as the soft limiter.

$$G_{i\_lim} = \tanh(\alpha G_i + \beta) + \gamma \tag{6}$$

where $\alpha$, $\beta$ and $\gamma$ are limiter parameters, which depend on the system configuration, $\alpha$ may be a real number greater than zero, and $\beta$ and $\gamma$ may be non-zero real numbers. At this moment, $G_{i\_lim}$ may serve as the output from gain control module 110.

FIG. 4 exemplarily shows a schematic diagram of a dynamic loudness balancing process of each channel according to one or more embodiments of the present disclosure. The dynamic loudness balancing processing of FIG. 4 may be performed by dynamic loudness balancing module 104. For example, after receiving the multi-channel source input, dynamic loudness balancing module 104 first performs channel extraction to extract a center channel signal. Then, the loudness of the center channel signal is enhanced, and the loudness of other channel signals is reduced based on the gain control parameter. Then, the enhanced center channel signal and the reduced other channel signals are concatenated and mixed to generate an output signal. The gain control parameter may be a current gain control parameter or an updated gain parameter. For example, in the case where the first path signal processing and the second path signal processing are synchronous, the gain control parameter used for the dynamic loudness balancing of a signal of a current time frame (for example, the *ith* time frame) is a calculated gain control parameter updated in real time, for example, $Gi$ or $G_{i\_lim}$ updated in real time. **In** the case where the first path signal processing and the second path signal processing are asynchronous, since the speed of the second path signal processing including voice detection and gain estimation is relatively low, the gain control parameter used for the dynamic loudness balancing of a signal of a current time frame (for example, the ith time frame) may be the gain control parameter used for the dynamic loudness balancing of the signal of the previous time frame, such as $G_{i-n}$ or $G_{i\_n\_lim}$, where n is an integer greater than 0, and the value thereof may vary depending on the actual processing power of the system or the practical experience of engineers. Furthermore, based on the current/updated gain control parameter, the signal in the center channel and the signals in the other channels may be enhanced and reduced at different ratios, respectively. That is, an enhancement control parameter for enhancing the loudness of the center channel signal and an attenuation control parameter for reducing the loudness of the center channel signal may be further determined based on the current/updated gain control parameter, respectively. For example, the enhancement control parameter and the attenuation control parameter may be determined by proportional calculation, function calculation, or other calculation methods set by engineers according to system requirements or experience. As a result, the overall loudness of the system remains unchanged, but the loudness of each channel is dynamically balanced.

FIG. 5 shows a schematic diagram of a method and system according to one or more embodiments of another implementation of the present disclosure. In one or more embodiments shown in FIG. 5, the method and system of processing audio source input signals in the present disclosure involve the following parts: source input module 502, dynamic loudness balancing module 504, signal output module 506, voice detection module 508, and gain control module 510. These modules operate on substantially the same principles as the corresponding modules 102-110 in FIG. 1. Besides, the method and system shown in FIG. 5 may further include crossover filtering module 512. It will be understood that the difference between the processing procedure shown in FIG. 5 and the processing procedure described above with reference to FIGS. 1-4 is that crossover filtering is added to a first signal path. Therefore, a source input signal received from input module 502 is processed by crossover filtering module 512 first, and then is processed by dynamic loudness balancing module 504 for dynamic loudness balancing. Since the frequency range of human voice is basically in a mid frequency range, a crossover filter may be selected to process the input signal to distinguish signals in different frequency ranges. Thus, gain control is only applied to a signal in the mid frequency range in the input signal, while signals in other frequency ranges in the input signal remain unchanged. Through the added crossover filtering, it is possible to perform the dynamic loudness balancing only on the signal in the mid frequency range in the source input signal, so as to avoid distortion in a non-voice frequency range as much as possible. In order to save space, only the different parts of the embodiments shown in FIG. 5 and FIG. 1 will be described below. For other identical parts, please refer to FIGS. 1-4 and the related descriptions.

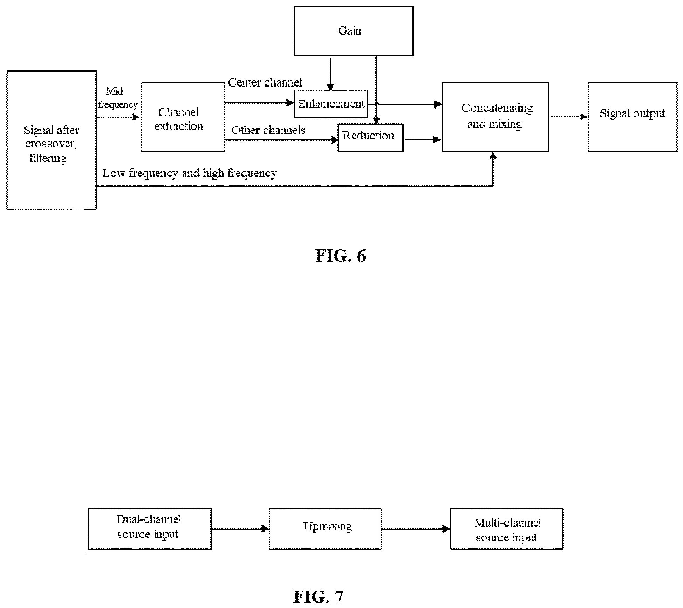

FIG. 6 shows a schematic diagram of a dynamic loudness balancing process according to one or more embodiments of the implementation in FIG. 5. As shown in FIG. 6, the source input signal after the crossover filtering may include signals in mid frequency, high frequency, and low frequency ranges. Next, dynamic loudness balancing is performed only on signals in the mid frequency range. The dynamic loudness balancing includes channel extraction to extract a center channel signal. Then, the loudness of the center channel signal is enhanced and the loudness of other channel signals is reduced based on a current/updated gain control parameter. The signals in the low frequency range and the high frequency range in the multi-channel source input signal will not be subjected to the dynamic loudness balancing, but will be directly concatenated and mixed with the signals in the mid frequency range after the dynamic loudness balancing to generate an output signal. Thus, the distortion caused by a non-voice signal may be better avoided.

A number of processing procedures performed in the case where the source input is a multi-channel source input with a center channel are described above in conjunction with FIG. 1 to FIG. 6. Those skilled in the art may understand from the present disclosure that if the source input is a single-channel input, the processing procedures shown in FIG. 1 to FIG. 6 may also be performed, wherein the process of center channel extraction will be omitted. That is, the signal processing of two paths described above is performed directly on the single-channel source input.

In the case where the source input is a dual-channel source input, it is necessary to add a center extraction process in advance before implementing the method and system disclosed above, so that a multi-channel source input is generated based on the dual-channel source input. FIG. 7 schematically shows a process of generating a multi-channel source input based on a dual-channel source input in the case where a source input is the dual-channel source input according to one or more embodiments of the present disclosure.

An upmixing process shown in FIG. 7 may adopt a center extraction algorithm, so as to output a multi-channel source input based on a dual-channel source input. A center extraction algorithm may, for example, include calculating a cross-correlation between left and right channel input signals, and combining the left and right channel input signals into a center channel signal, wherein the combination ratio depends on the cross-correlation, referring to the following equation (7):

$$\text{center}(n) = \theta * \text{corr}\big(\text{left}(n), \text{right}(n)\big) * \big(\text{left}(n) + \text{right}(n)\big) \qquad (7)$$

where left(n) is the left channel input signal, right(n) is the right channel input signal, center(n) is the center channel signal, corr() represents a cross-correlation function, $\theta$ is a tuning parameter in practice, and $\theta$ is greater than 0 and less than or equal to 1.

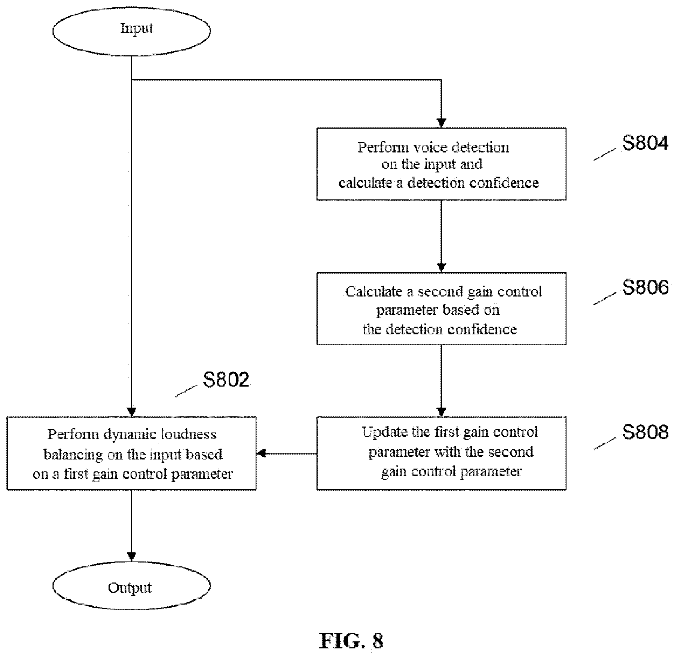

FIG. 8 schematically shows a method for dynamic voice enhancement according to one or more embodiments of the present disclosure. As shown in FIG. 8, the method includes performing a first path signal processing. The first path signal processing includes receiving an audio source input and performing dynamic loudness balancing on the audio source input based on a first gain control parameter S802. The method also includes performing a second path signal processing. The second path signal processing includes: performing voice detection on the audio source input and calculating a detection confidence S804; and calculating a second gain control parameter based on the detection confidence S806. The method may also include updating the first gain control parameter with the second gain control parameter S808, and performing the first path signal processing based on the updated first gain control parameter S802. The method shown in FIG. 8 may be performed by a processor.

The method and system provided by the present disclosure may be applied not only to consumer products such as Soundbars and stereo speakers, but also to products in cinema applications such as theaters and concert halls. The method and system provided by the present disclosure can better enhance the intelligibility of voice and improve the user's experience of using audio products and applications. The above-mentioned method and system described in the present disclosure with reference to the accompanying drawings may both be implemented by a processor.

For example, unless otherwise indicated, one or more of the methods described may be performed by a suitable device and/or a combination of devices. The method may be performed by using one or more logic devices (for example, processors) in combination with one or more additional hardware elements (such as storage devices, memories, hardware network interfaces/antennas, switches, actuators, clock circuits, etc.) to perform stored instructions. The method described and associated actions may also be executed in parallel and/or simultaneously in various orders other than the order described in this application. The system described is illustrative in nature, and may include additional elements and/or omit elements. The subject matter of the present disclosure includes all novel and non-obvious combinations of the disclosed various systems and configurations as well as other features, functions, and/or properties.

The system may include additional or different logic, and may be implemented in many different ways. The processor may be implemented as a microprocessor, a microcontroller, an Application Specific Integrated Circuit (ASIC), digital signal processor DSP, discrete logic, or a combination of these and/or other types of circuits or logic. Similarly, the memory may be a DRAM, a SRAM, a flash memory, or other types of memory. Parameters (for example, conditions and thresholds) and other data structures may be stored and managed separately, may be combined into a single memory or database, or may be logically and physically organized in many different ways. Programs and instruction sets may be parts of a single program, or separate programs, or distributed across a plurality of memories and processors.

As used in this application, an element or step listed in the singular form and preceded by the word "a/one" should be understood as not excluding a plurality of said elements or steps, unless such exclusion is indicated. Furthermore, references to "one implementation" or "one example" of the present disclosure are not intended to be interpreted as excluding the existence of additional implementations that also incorporate the recited features.

**Claims**

1. A method of dynamic voice enhancement, comprising:

performing a first path signal processing, the first path signal processing comprising receiving an audio source input and performing dynamic loudness balancing on the audio source input based on a first gain control parameter;

performing a second path signal processing, the second path signal processing comprising:

performing voice detection on the audio source input and calculating a detection confidence, wherein the detection confidence indicates the possibility of voice in the audio source input; and

calculating a second gain control parameter based on the detection confidence; and

updating the first gain control parameter with the second gain control parameter, and performing the first path signal processing based on the updated first gain control parameter;

wherein the audio source input comprises a multi-channel source input, and the performing voice detection on the audio source input and calculating a detection confidence comprises:

extracting a center channel signal from the multi-channel source input;

performing normalization on the center channel signal; and

performing fast autocorrelation on the normalized center channel signal, the result of the fast autocorrelation representing the detection confidence.

2. The method according to claim 1, wherein the calculating a second gain control parameter based on the detection confidence comprises:

calculating the second gain control parameter based on a logarithmic function of the detection confidence;

smoothing the calculated second gain control parameter; and

limiting the smoothed second gain control parameter.

3. The method according to any preceding claim, wherein the audio source input comprises a multi-channel source input, and the performing dynamic loudness balancing on the audio source input comprises:

extracting a center channel signal from the multi-channel source input;

enhancing the loudness of the center channel signal and reducing the loudness of other channel signals based on the first gain control parameter or the updated first gain control parameter; and

concatenating and mixing the enhanced center channel signal and the reduced other channel signals to generate an output signal.

4. The method according to any preceding claim, further comprising: performing crossover filtering on the audio source input before performing the dynamic loudness balancing.

5. The method according to claim 4, further comprising:

performing the dynamic loudness balancing only on signals in a mid frequency range of the audio source input; and

concatenating and mixing signals in a low frequency range and a high frequency range of the audio source input and signals in the mid frequency range of the audio source input after the dynamic loudness balancing to generate the output signal.

6. The method according to any preceding claim, wherein the audio source input further comprises a dual-channel source input, and the method further comprises generating a multi-channel source input including a center channel based on the dual-channel source input.

7. The method according to claim 6, wherein the generating a multi-channel source input based on the dual-channel source input comprises:

performing a cross-correlation between a left channel signal and a right channel signal from the dual-channel source input; and

generating the multi-channel source input according to a combination ratio,

wherein the combination ratio depends on the result of the cross-correlation.

8. The method according to any preceding claim, wherein the first path signal processing and the second path signal processing are synchronous or asynchronous.

9. A system of dynamic voice enhancement, comprising:

a memory configured to store computer-executable instructions; and

a processor configured to execute the computer-executable instructions to implement the method according to any one of claims 1-8.

**Patentansprüche**

1. Verfahren zur dynamischen Sprachverbesserung, umfassend:

Durchführen von Verarbeitung eines Signals eines ersten Pfads, wobei die Verarbeitung des Signals des ersten Pfads Empfangen einer Audioquelleneingabe und Durchführen eines dynamischen Lautstärkeausgleichs an der Audioquelleneingabe basierend auf einem ersten Verstärkungsregelungsparameter umfasst;

Durchführen von Verarbeitung eines Signals eines zweiten Pfads, wobei die Verarbeitung des Signals des zweiten Pfads Folgendes umfasst:

Durchführen von Spracherkennung an der Audioquelleneingabe und Berechnen einer Erkennungskonfidenz, wobei die Erkennungskonfidenz die Möglichkeit von Sprache in der Audioquelleneingabe anzeigt; und Berechnen eines zweiten Verstärkungsregelungsparameters basierend auf der Erkennungskonfidenz; und Aktualisieren des ersten Verstärkungsregelungsparameters mit dem zweiten Verstärkungsregelungsparameter und Durchführen der Verarbeitung des Signals des ersten Pfads basierend auf dem aktualisierten ersten Verstärkungsregelparameter;

wobei die Audioquelleneingabe eine Mehrkanalquelleneingabe umfasst und das Durchführen von Spracherkennung an der Audioquelleneingabe und das Berechnen einer Erkennungskonfidenz Folgendes umfassen:

Extrahieren eines Mittelkanalsignals aus der Mehrkanalquelleneingabe;
Durchführen einer Normalisierung an dem Mittelkanalsignal; und
Durchführen einer schnellen Autokorrelation an dem normalisierten Mittelkanalsignal, wobei das Ergebnis der schnellen Autokorrelation die Erkennungskonfidenz darstellt.

2. Verfahren nach Anspruch **1,** wobei das Berechnen eines zweiten Verstärkungsregelungsparameters basierend auf der Erkennungskonfidenz Folgendes umfasst:

Berechnen des zweiten Verstärkungsregelungsparameters basierend auf einer logarithmischen Funktion der Erkennungskonfidenz;
Glätten des berechneten zweiten Verstärkungsregelungsparameters; und
Begrenzen des geglätteten zweiten Verstärkungsregelungsparameters.

3. Verfahren nach einem der vorhergehenden Ansprüche, wobei die Audioquelleneingabe eine Mehrkanalquelleneingabe umfasst und das Durchführen des dynamischen Lautstärkeausgleichs an der Audioquelleneingabe Folgendes umfasst:

Extrahieren eines Mittelkanalsignals aus der Mehrkanalquelleneingabe;
Verbessern der Lautstärke des Mittelkanalsignals und Reduzieren der Lautstärke anderer Kanalsignale basierend auf dem ersten Verstärkungsregelungsparameter oder dem aktualisierten ersten Verstärkungsregelparameter; und
Verketten und Mischen des verbesserten Mittelkanalsignals und der reduzierten anderen Kanalsignale, um ein Ausgabesignal zu erzeugen.

4. Verfahren nach einem der vorhergehenden Ansprüche, ferner umfassend: Durchführen von Crossover-Filterung an der Audioquelleneingabe vor dem Durchführen des dynamischen Lautstärkeausgleichs.

5. Verfahren nach Anspruch **4,** ferner umfassend:

Durchführen des dynamischen Lautstärkeausgleichs nur bei Signalen in einem mittleren Frequenzbereich der Audioquelleneingabe; und
Verketten und Mischen von Signalen in einem niedrigen Frequenzbereich und einem hohen Frequenzbereich der Audioquelleneingabe und Signalen in dem mittleren Frequenzbereich der Audioquelleneingabe nach dem dynamischen Lautstärkeausgleich, um das Ausgabesignal zu erzeugen.

6. Verfahren nach einem der vorhergehenden Ansprüche, wobei die Audioquelleneingabe ferner eine Zweikanalquelleneingabe umfasst und das Verfahren ferner Erzeugen einer Mehrkanalquelleneingabe, die einen Mittelkanal beinhaltet, basierend auf der Zweikanalquelleneingabe umfasst.

7. Verfahren nach Anspruch 6, wobei das Erzeugen einer Mehrkanalquelleneingabe basierend auf der Zweikanalquelleneingabe Folgendes umfasst:

Durchführen einer Kreuzkorrelation zwischen einem Signal eines linken Kanals und einem Signal eines rechten Kanals von der Zweikanalquelleneingabe; und
Erzeugen der Mehrkanalquelleneingabe gemäß einem Kombinationsverhältnis,
wobei das Kombinationsverhältnis von dem Ergebnis der Kreuzkorrelation abhängt.

**8.** Verfahren nach einem der vorhergehenden Ansprüche, wobei die Verarbeitung des Signals des ersten Pfads und die Verarbeitung des Signals des zweiten Pfads synchron oder asynchron sind.

**9.** System zur dynamischen Sprachverbesserung, umfassend:

einen Speicher, der dazu ausgelegt ist, computerausführbare Anweisungen zu speichern; und
einen Prozessor, der dazu ausgelegt ist, die computerausführbaren Anweisungen auszuführen, um das Verfahren nach einem der Ansprüche 1-8 zu implementieren.

**Revendications**

**1.** Procédé d'amélioration dynamique de la voix, comprenant :

la réalisation d'un premier traitement de signal de chemin, le premier traitement de signal de chemin comprenant la réception **d'une** entrée de source audio et l'exécution **d'un** équilibrage dynamique du volume sonore sur l'entrée de source audio sur la base d'un premier paramètre de commande de gain ;
la réalisation d'un traitement de signal de second chemin, le traitement de signal de second chemin comprenant :

la réalisation d'une détection vocale sur l'entrée de la source audio et le calcul **d'une** confiance de détection, dans lequel la confiance de détection indique la possibilité de voix dans l'entrée de la source audio ; et
le calcul d'un second paramètre de commande de gain basé sur la confiance de détection ; et
la mise à jour du premier paramètre de commande de gain avec le second paramètre de commande de gain, et la réalisation du premier traitement du signal de chemin sur la base du premier paramètre de commande de gain mis à jour ;
dans lequel l'entrée de source audio comprend une entrée de source multicanal, et la réalisation **d'une** détection vocale sur l'entrée de source audio et le calcul d'une confiance de détection comprennent :

l'extraction **d'un** signal de canal central de l'entrée source multicanal ;
la réalisation d'une normalisation sur le signal du canal central ; et
la réalisation **d'une** autocorrélation rapide sur le signal du canal central normalisé, le résultat de l'autocorrélation rapide représentant la confiance de détection.

**2.** Procédé selon la revendication 1, dans lequel le calcul d'un second paramètre de commande de gain basé sur la confiance de détection comprend :

le calcul du second paramètre de commande de gain sur la base d'une fonction logarithmique de la confiance de détection ;
le lissage du second paramètre de commande de gain calculé ; et
la limite du second paramètre de commande de gain lissé.

**3.** Procédé selon une quelconque revendication précédente, dans lequel l'entrée de source audio comprend une entrée de source multicanal, et **l'équilibrage** dynamique du volume sonore sur l'entrée de source audio comprend :

l'extraction **d'un** signal de canal central de l'entrée source multicanal ;
l'amélioration du volume du signal du canal central et la réduction du volume des autres signaux du canal en fonction du premier paramètre de commande de gain ou du premier paramètre de commande de gain mis à jour ; et
la concaténation et le mélange du signal du canal central amélioré et des autres signaux de canal réduits pour générer un signal de sortie.

**4.** Procédé selon une quelconque revendication précédente, comprenant également : la réalisation d'un filtrage croisé sur **l'entrée** de la source audio avant la réalisation de l'équilibrage dynamique du volume sonore.

**5.** Procédé selon la revendication **4,** comprenant également :

la réalisation de l'équilibrage dynamique du volume uniquement sur les signaux dans une plage de fréquences moyennes de l'entrée de la source audio ; et
la concaténation et le mélange de signaux dans une gamme de basses fréquences et une gamme de hautes fréquences de l'entrée de la source audio et de signaux dans la gamme de moyennes fréquences de l'entrée de la source audio après l'équilibrage dynamique du volume sonore pour générer le signal de sortie.

**6.** Procédé selon une quelconque revendication précédente, dans lequel l'entrée de source audio comprend également une entrée de source à double canal, et le procédé comprend également la génération d'une entrée de source multicanal comportant un canal central sur la base de l'entrée de source à double canal.

**7.** Procédé selon la revendication **6,** dans lequel la génération d'une entrée source multicanal basée sur l'entrée source double canal comprend :

la réalisation d'une corrélation croisée entre un signal de canal gauche et un signal de canal droit provenant de l'entrée source à double canal ; et
la génération de l'entrée source multicanal selon un rapport de combinaison,
dans lequel le rapport de combinaison dépend du résultat de la corrélation croisée.

**8.** Procédé selon une quelconque revendication précédente, dans lequel le traitement du signal du premier chemin et le traitement du signal du second chemin sont synchrones ou asynchrones.

**9.** Un système d'amélioration dynamique de la voix, comprenant :

une mémoire configurée pour stocker des instructions exécutables par ordinateur ; et
un processeur configuré pour exécuter les instructions exécutables par ordinateur pour mettre en œuvre le procédé selon une quelconque revendication 1 à 8.

**FIG. 1**

**FIG. 2**

Input of autocorrelation result → Dynamic control → Smoothing → Soft limiter → Gain

## FIG. 3

Gain

Center channel

Multi-channel source input → Channel extraction → Enhancement → Concatenating and mixing → Signal output

Reduction

Other channels

## FIG. 4

508 Voice detection → 510 Gain control

502 Source input → 512 Crossover filtering → 504 Dynamic loudness balancing → 506 Signal output

## FIG. 5

**FIG. 6**

**FIG. 7**

Input

Perform voice detection
on the input and
calculate a detection confidence

S804

Calculate a second gain control
parameter based on
the detection confidence

S806

S802

Perform dynamic loudness
balancing on the input based
on a first gain control parameter

Update the first gain control
parameter with the second
gain control parameter

S808

Output

**FIG. 8**

REFERENCES CITED IN THE DESCRIPTION

**Patent documents cited in the description**

- US 20100179808 A1